# EUROPEAN PATENT APPLICATION

(11) **EP 4 350 274 A1**
(43) Date of publication of application: **10.04.2024**
(21) Application number: 22382929.2
(22) Date of filing: 05.10.2022
(51) Int. Cl.: F28F 3/02

(54) **HEAT EXCHANGER**

(71) Applicant: BORGWARNER EMISSIONS SYSTEMS SPAIN, S.L.U., 36315 Vigo Pontevedra (ES)
(72) Inventor: HERMIDA, Xoán, E-36380 Gondomar (ES); LOZANO, Francisco, E-36400 O Porriño (ES); LAGO, David, E-36201 Vigo (ES); LORENZO GONZÁLEZ, Manuel, E-36413 Mosende, O Porriño (ES); ABELAIRAS, Óscar, E-36209 Vigo (ES)
(74) Representative: ABG Intellectual Property Law, S.L.

(57) **Abstract**

The present description relates to a flat heat exchanger of the types which use a single working fluid circulating continuously through the inside of one or a plurality of heat transmission conduits for cooling one or more electric or electronic components or the like located in a position close to or in contact with a region of the outer part of at least one heat transmission conduit.

## Description

### OBJECT OF THE INVENTION

The present description relates to a flat heat exchanger of the types which use a single working fluid circulating continuously through the inside of one or a plurality of heat transmission conduits for cooling one or more electric or electronic elements or components or the like located in a position close to or in contact with a region of the outer part of at least one heat transmission conduit.

### BACKGROUND OF THE INVENTION

In recent years, one of the most intensively developed fields of the art is the field of electric or hybrid vehicles, and accordingly also of their different components.

Different types of power electronic components suitable for being installed in electric or hybrid vehicles, such as semiconductor devices intended for switching, amplifiers, power switches, or in DC-DC converters, on-board chargers, etc., require systems for cooling them. It is known that temperature negatively affects component service life and the temperature of the component must be controlled such that it falls within specific temperature ranges. Given the increasing miniaturization of electronic elements or components, elements of this type require heat to be discharged into very small areas which, however, lead to the generation of a lot of heat. This is the case of switching devices used for powering resistors or IGTBs used in inverters with high switching rates.

Semiconductor devices are usually protected by a casing or embedded in a plastic body. Heat is usually discharged from the outer surface of the casing or of the protective body.

Similarly, systems are required for cooling the batteries of electric or hybrid vehicles. It is known that battery temperature is the key factor in battery life, performance, and safety. For example, the performance of lithium-ion batteries depends greatly on their operating temperature and said batteries do not work correctly when they are subjected to too high or too low temperatures. For this reason, electric vehicle manufacturers and suppliers seek to improve battery thermal management systems in order to control the temperature of battery cells such that it falls within the safe and efficient established limits which cool or heat said cells, where necessary, and to achieve a battery service life that is at least as long as the service life of the vehicle in which the battery is installed.

In this regard, electric or hybrid vehicles typically use cooling systems for cooling certain power electronic components or battery cells.

Different thermal management systems for said power electronic components or batteries are available on the market: active and passive thermal management systems which can in turn be classified by different concepts.

First, they are classified by the purpose of the thermal management system: heating, cooling, or both. Second, they are classified by the means used to achieve said purpose, which can be air or liquid. Lastly, they are classified by the source used for thermal control. The system is a passive thermal management system if the liquid or air introduced into the battery compartment enters said compartment without prior additional preconditioning and it is an active thermal management system if a specific temperature-control component is installed previously.

Active thermal management systems for said power electronic components or batteries are generally based on the forced circulation of specific substances such as water and air around the battery or the external component with which heat exchange is to be performed.

This invention focuses on active cooling systems, wherein the heat exchange fluid is typically a liquid coolant, and wherein the liquid coolant can be, for example: a natural coolant such as water, or a mixture of water and an organic substance-based antifreeze, such as ethylene glycol.

In general, the concept of a heat exchanger is a device used for forcing the exchange of energy, in the form of heat, between at least two heat sources at different temperatures, typically two fluids. However, heat exchangers referred to in this invention comprise a structure designed to establish a thermal communication between a single heat transmission fluid, which flows continuously in a confined manner through the inside of at least one conduit of the heat exchanger, and an external element or component arranged outside of, but in thermal contact with, the heat exchange conduit. In this way, heat transmission occurs through physical walls separating the heat transmission fluid from the external element or component, i.e., through one or more walls of the conduit(s), depending on whether the component is in contact with only one conduit or interposed between two different conduits.

One of the heat exchangers conventionally used in the field of the active cooling of power electronic components or batteries that are, for example, suitable for being installed in electric or hybrid vehicles is the flat heat exchanger. The flat heat exchanger is typically made up of one or a plurality of heat exchange conduits through which a heat transmission fluid flows continuously, said fluid being capable of cooling one or more electric or electronic elements or components or similar external electric or electronic elements or components, with said electric or electronic elements or components being located in a position close to or in close thermal contact with the outer part of the heat transmission conduit(s).

In this way, the heat transmission fluid transmits or receives heat through the material of the conduit (generally a metal wall), separating the heat transmission fluid from the external physical element(s) or component(s), thereby forcing convection through the heat transmission fluid (which is generally at a lower temperature than the external element(s) or component(s)) and heat conduction through the material of the conduit walls from the external element(s) or component(s) (which generally is/are at a higher temperature than the heat transmission fluid).

However, heat exchange in the heat exchanger of the present invention is not aimed solely at cooling one or more external electric or electronic elements or components, arranged in specific positions in the outer part of the heat exchanger, but also can be used for cooling, or even heating, an object or element arranged in a specific external position with respect to the flow passage conduit(s), which are not strictly a power electronic component or a battery for an electric or hybrid vehicle.

A known configuration of a flat heat exchanger for such purpose is formed by one or a plurality of flow passage conduits (which will be referred to herein interchangeably as flow passage conduits or heat exchange conduits) for interposing one or more elements to be cooled between the plurality of conduits arranged in a stack. With this configuration, both sides of the conduit contribute to heat transfer, and heat dissipation thereby increases.

Flat heat exchangers which, for the purpose of improving heat exchange performance, have on the inside of each heat exchange conduit, an intermediate flat plate-like partitioning element, are known, said partitioning element forming a middle flow path through which the heat exchange flow flows into a two-stage enveloping heat exchange conduit in the direction of the thickness of the heat exchange tube in the shape of a flat cross-section.

Furthermore, an inner fin is arranged in each of the fluid flow paths formed in the two stages. The use of inner fins in exchangers of this type to create turbulences in the passage of the coolant fluid in the flow direction, and accordingly to increase heat extraction from the fluid through the walls, is known. In this known configuration, the enveloping heat exchange conduit can be configured by two covers with a shape such that they constitute an enveloping flow passage tub, inside which an inner fin is arranged in each of the two stages.

The elements constituting the heat exchanger are generally manufactured from a metal material having a high thermal conductivity, such as aluminum, copper, or alloys thereof. Furthermore, the members constituting the heat exchanger are generally attached by means of brazing, being heated in a heating oven after being combined with one another in the heat exchanger manufacturing process.

The inner fin, also known as turbulator, is typically configured as a compact element of little thickness, extending along the flow direction. It has a width slightly smaller than the width of the flow conduit and a length smaller than the length of the flow conduit so that it can fit inside the conduit. The turbulator may have different configurations for the purpose of increasing heat transmission from the external element to be cooled to the coolant fluid. One possible way is to design one or more channels extending in a wavy manner along the flow direction, such that it forms one or a plurality of wavy paths, in which the heat exchange fluid meanders and flows along said divided paths. There may be other intersection elements in the turbulator for modifying the flow inside the conduit by increasing fluid turbulence.

An objective sought by flat heat exchangers is to minimize, as much as possible, the pressure drop of the coolant fluid during its passage through the inside of the heat transmission conduit, to thereby maximize the efficiency of heat transfer with the external element(s) or component(s). In the state of the art, it is considered that where there is no heat exchange with an external element or component to be cooled, what is sought is that there is no pressure drop in the heat transmission fluid.

Pressure drop in a pipe or conduit is the pressure drop that occurs in a fluid due to the fluid particles brushing against one another and against the walls of the conduit guiding the fluid. Therefore, one skilled in the art knows that, in order to minimize the pressure drop in the heat transmission fluid along the inside of the conduit, there is a need to avoid interposing any type of element which may somehow disrupt or block fluid flow in the flow direction, for example, any element which generates a limit layer generating an entrainment effect causing the pressure drop. For said reason, in the specific locations or segments of the turbulators where there is no external element or component to be cooled nearby, no element or obstacle (such as a fin or any other type of disrupting element) which may intersect the flow path is provided, with the path for fluid flow in that specific segment thereby being left completely free of any obstacle.

Pressure drop has a negative influence on the performance of the heat exchanger since it directly affects the flow rate of the coolant flow which is capable of circulating therethrough and increases the energy cost required for driving the movement of the liquid coolant. The coolant flow rate is proportional to the heat energy discharged in the heat exchanger, so an increase in pressure drop directly affects the reduction of the heat exchanged.

The second problem identified in the state of the art associated with flat heat exchangers of this type is that since they have little thickness and a certain length extending along the flow direction, they must have sufficient flexural rigidity, i.e., sufficient flexural strength. In those cases in which sufficient rigidity is not achieved, the heat exchanger may experience excessive deformation or may even break, particularly during its manufacturing or assembly phase. In the particular case of an exchanger with a turbulator provided with segments with non-straight fins, wherein two segments with non-straight fins are intercalated with an empty segment without fins, the coefficient of rigidity thereof cannot reach the required values. Therefore, there is a need to design an improved heat exchanger with a turbulator, and wherein the heat exchanger has a coefficient of rigidity, mainly flexural rigidity, that is sufficient for such uses.

The main problem that this invention seeks to sole is to provide a flat heat exchanger, formed by one or more heat transmission conduits through the inside of which a coolant fluid circulates continuously, said coolant fluid being capable of cooling one or more electric or electronic elements or components or the like located in a position close to the external part of the heat transmission conduit(s), such that this coolant fluid exchanges heat through the wall of the conduit separating the fluid from the physical external component(s), thereby forcing heat convection and conduction from the external component(s) (generally at a higher temperature) to the fluid (generally at a lower temperature) and with the particularity that the heat exchanger has a lower pressure drop compared to other heat exchangers existing today, and at the same time, without the thermal resistance worsening.

### DESCRIPTION OF THE INVENTION

The present invention provides a solution to the problems mentioned above, by means of a heat exchanger, preferably a flat heat exchanger, according to claim 1, which uses a single heat exchange fluid for cooling or heating one or more external elements or components with respect to the heat exchanger, wherein said one or more external elements or components are arranged close to or in contact with a region of the outer surface of one or more fluid exchange conduits of the heat exchanger through which the heat exchange fluid flows. The dependent claims define preferred embodiments of the invention.

In a first inventive aspect, the invention provides *a heat exchanger comprising:*
- *at least one conduit adapted to allow the flow of a coolant fluid from a coolant fluid inlet cross-section to a coolant fluid outlet cross-section, the conduit comprising at least one heat exchange wall, wherein the exchange wall comprises at least one region on its outer surface configured for being in thermal contact with at least one external element or component, the heat exchange region on the outer surface of the heat exchange wall having a corresponding thermal footprint region on the inner surface of the heat exchange wall, wherein the thermal footprint region corresponds to the projection of the region of the outer surface of the exchange wall configured for being in thermal contact with at least one external element or component, or a group thereof, according to the direction perpendicular to the exchange wall;*
- *at least one turbulator placed inside the at least one conduit to increase heat exchange, wherein the at least one turbulator extends along the flow direction of the coolant fluid; wherein the at least one turbulator further comprises at least one flow channel through which coolant fluid flows in the flow direction, wherein the at least one flow channel comprises at least one segment with fins which are not straight in the flow direction and at least one segment with fins which are straight in the flow direction, wherein*
   *the at least one segment with non-straight fins and the at least one segment with straight fins are arranged in adjacent positions and distributed along the flow direction,*
   *the at least one flow channel of the segment with non-straight fins is connected continuously along the flow direction with the corresponding flow channel of the adjacent segment with straight fins, such that a continuous flow path of the coolant fluid along the flow direction is configured,*
   *each segment with non-straight fins comprises mainly a thermal footprint region to improve heat exchange, and*
   *each segment with straight fins comprises mainly a region outside of any thermal footprint region to reduce pressure drop.*

In this application, the term "external element or component" is understood to mean any element or component or device which is external with respect to the heat exchanger of the invention, and arranged and configured for being cooled preferably by the heat exchanger, since the external element or component is at a higher temperature than the coolant fluid in the heat exchanger. It is also understood that the "external element or component" is arranged close to or in contact with a region of the outer heat exchange surface of one or more conduits of the heat exchanger through which the coolant fluid flows. Preferably, said external element or component is a heat source, a battery cell, or an electric or electronic component to be cooled, although it could be a similar element. However, in some specific cases, such as in "cold-plates" of batteries, where the aim is to enable both cooling and heating the cell with the same heat exchanger depending on needs, the heat exchanger of the invention can also be arranged and configured for heating the external element(s) or component(s).

In this application, the term "being in thermal contact with" is understood to mean being in a close physical position or in close contact, such that heat conduction is established between the elements that are in thermal contact. For example, an intermediate element or substance may be arranged between the outer surface of the heat transfer conduit and the external element or component to be cooled, such that the thermal contact between both does not have to be a direct contact between the elements, but rather with the intermediation of another element or substance which does not interrupt heat conduction between the elements or can even favor same.

In this application, the term "turbulator" or "inner fin" is understood, interchangeably, to mean a component which causes increased heat exchange by enhancing the coefficient of heat exchange through convection caused by an increase in the contact area with the coolant fluid, leading in some cases to turbulence. Examples of turbulator elements are fins, permeable foams, protrusions emerging from the surface of the conduit directing the flow, etc. In the preferred examples of the invention, the "turbulator" element is formed by a set of sheet-like fins. More specifically, the described examples will use of a set of sheet-like fins where the sheet is folded forming passage channels for the fluid.

In this application, the term "coolant fluid" is understood to mean a liquid intended for exchanging heat by convection with an exchange surface and transporting it to favor the cooling or heating of the surface. In particular, the liquid coolant can be water mixed with an ethylene glycol-based antifreeze, or water mixed with an organic substance such as ammonia, or a natural coolant such as water. The term "coolant" should not be interpreted as limiting the function of the heat exchanger to cooling one or more external elements or components, given that, in some specific cases of the invention, the fluid can work to heat the external component(s). Therefore, the term "coolant fluid" in the present application should be interpreted as a "heat exchange fluid" suitable for exchanging heat (cooling or heating) with one or more external elements or components with respect to the heat exchanger which are at a temperature different from the fluid temperature.

In this application, the term "thermal footprint region" is understood to mean an inner surface of the heat exchange wall defined by the projection of the region configured to be in thermal contact with at least one external element or component with respect to the exchanger that is to be cooled or heated, i.e., the projection defined according to a direction perpendicular to the exchange wall where the heat exchange region is located. Accordingly, there may be a single external element or component with respect to the exchanger that is to be cooled or heated or more than one external element or component in the same thermal footprint region. If there is more than one external element or component close to one another comprised in a thermal footprint region, it is understood that this thermal footprint region corresponds to the perimeter of the minimum rectangle containing therein neighboring external elements or components forming a group.

It is understood that two or more external heat-generating elements or components form a group when their distances from one another are smaller than the distances between the minimum rectangles contained in each group.

The particular design of the at least one turbulator of the heat exchanger of the invention with a configuration such that, where no external element or component is nearby, such as a heat source, there is envisaged a segment with fins formed by one or more straight fins generating segments of flow channels which follow a rectilinear path in the flow direction, and wherein said flow channels of the segment with straight fins being connected continuously (i.e., without discontinuities) along the flow direction with the corresponding adjacent flow channels of a segment with non-straight fins of the same turbulator provides several advantages over existing heat exchangers, as set forth by applicant.

First, the applicant has observed empirically that the attachment or connection of segments having non-straight channels by means of straight channels gives rise to a guided fluid flow which advantageously reduces the pressure drop of the fluid in the areas where a high cooling performance is not required, despite of the establishment of additional surfaces which cause a flow entrainment effect.

In that sense, with this new design of the heat exchanger of the invention, contrary to what was expected, a lower pressure drop is obtained compared to that which would be obtained if no fin were arranged between the segments of curved conduits and the section of the conduit were free. In other words, the invention allows achieving a reduction of pressure drop with respect to other type of heat exchanger, and also a thermal performance similar to the performance of conventional heat exchangers with wavy fins, wherein these segments with wavy fins are located only in the thermal footprint regions. In that sense, an optimal cooling performance and improved behavior in the pressure drop of the coolant fluid are obtained with the heat exchanger of the invention.

Second, the applicant has demonstrated that by arranging in the heat exchanger of the invention a turbulator having one or more segments with straight channels connecting consecutive segments with non-straight channels, the rigidity, mainly the flexural rigidity, of the heat exchanger is increased. In other words, an exchanger with a continuous turbulator, formed by the intercalation of segments with straight and non-straight fins, as proposed in the present invention, is more rigid compared to a heat exchanger with a conventional turbulator formed by a series of segments with non-straight fin separated from one another by a respective empty segment. In this application, an "empty segment" is understood to mean a segment of the turbulator without any fin.

Third, the applicant has demonstrated that, in some cases, the heat exchanger of the invention is more resistant to pressure fatigue.

As defined above, the at least one turbulator in the heat exchanger of the invention has at least one segment with fins which are not straight and at least one segment with fins which are straight. Segment(s) with non-straight fins are more efficient in heat exchange compared to segment(s) with straight fins, hence it is the configuration used in the thermal footprint region for the purpose of exchanging the largest possible amount of heat with the coolant fluid.

In this application, when the term "segment with non-straight fins" is described for the turbulator, it should be interpreted to mean that the fins in that area are configured such that the coolant fluid follows a non-straight path. For example, if a type of non-straight fins of the type which are offset in the flow direction is selected, the different segments forming the fin are straight but the path the fluid follows is not straight, because it hits against the edge of the walls (since the segments with fin are offset transversely) and this generates turbulence.

*Preferably, at least one segment with non-straight fins of a turbulator of the heat exchanger of the invention is a segment with fins selected from one of the following types: (a) wavy fins in the flow direction with a triangular profile or rounded profile (such as* a square wave with rounded corners or a sine wave), *or (b) fins offset in the flow direction. Preferably, in the case where the segment with non-straight fins is a segment with fins of a wavy type in the flow direction, the non-straight fin is in the shape of a wave with a channel-shaped cross-section substantially in the sine sector.* Preferably, all the different segments with non-straight fins forming the turbulator of the heat exchanger of the invention are a segment with fins selected from types "a" or "b" described above. Preferably, all the different segments with non-straight fins forming the turbulator of the heat exchanger of the invention are of the same type of fins.

In this application, a type of segments with fins "offset" in the flow direction is understood to mean a fin made up of different straight segments arranged along the flow direction. The axis of the even-numbered segments is offset in the transverse direction by a certain distance with respect to the axis of the odd-numbered segments.

In the first case "a" of a segment with wavy fins, the different segments making up the fin have an orientation following a non-straight path (specifically a wavy path in the longitudinal direction of the flow), such that the path of the fluid going through said fins meanders following said wavy paths. Furthermore, in the second case "b" of a segment with offset fins, the different segments making up the fin are straight, but the path of the fluid is not straight, because it hits against the edge of the walls of the fin (since the segments with fin are offset transversely).

In this application, when the term "segments with straight fins" is described for the turbulator, it should be interpreted to mean that the fins in that area have an orientation following a straight line according to the substantially longitudinal direction of the turbulator, i.e., the flow of the fluid passing through said segment with straight fins follows a rectilinear path in the longitudinal direction of the turbulator.

Preferably, the turbulator of the heat exchanger of the invention can have more than one segment with fins which are not straight and more than one segment with fins which are straight, wherein a segment with fins which are not straight is intercalated with a segment with fins which are straight. The number of different segments with fins of a turbulator according to the exchanger of the present invention can be any number equal to or greater than two (at least one segment with straight fins adjacent to a segment with non-straight fins), depending on the number of the element to be cooled (for example, an external heat source) by each heat exchanger model. By way of example, the following configurations of turbulators formed by different number of segments with fins are possible:
a) two segments: one segment with straight fins adjacent to a segment with non-straight fins, when there is only one external heat source to be cooled.
b) three segments: one segment with straight fins intercalated between two adjacent segments with non-straight fins, when there are two external heat sources to be cooled.
c) five segments: two segments with straight fins, with each segment with straight fins intercalated between two adjacent segments with non-straight fins, when there are three external heat sources to be cooled.

In this application, the term "heat exchange conduit" is understood to mean any possible configuration of a tube, conduit, or chamber, provided with walls forming an enclosure or inner hollow volume through which the heat exchange fluid can circulate in a confined manner along a direction, identified as the flow direction.

All the examples that will be described below use flat conduits, that is, conduits formed by two flat walls, a first wall corresponding to the heat exchange wall, a second wall spaced from the first wall, and side walls connecting the first and second walls. In some embodiments of the present invention, said second wall also exchanges heat. The conduit houses the turbulator which is also flat and has the thickness determined, or at least demarcated by, the separation between the surfaces of the flat walls of the conduit housing it. In this context, the term "thickness of the turbulator" is understood as the distance between these two surfaces of the flat walls of the conduit limiting it.

Preferably, the flat turbulator has thermal contact with at least one of the flat walls of the conduit housing it, for example by means of brazing.

The heat exchange wall according to these embodiments is one of the flat walls.

In the examples which will be described below, the channels of the segments with non-straight fins follow a winding path contained in a plane parallel to the flat surfaces demarcating the turbulator. According to a preferred embodiment, the winding path of the channels of the segments with non-straight fins is sinusoidal.

The flow channels established by the non-straight fin configuration present continuity with the flow channels established by the straight fin configuration, such that both segments are adjacent to one another. Continuity in the flow channels does not mean that there is continuity in the derivative of the path of the channels, although it is desirable.

Preferably, between a segment with non-straight fins and an adjacent segment with straight fins of the at least one turbulator of the heat exchanger of the present invention there is no intermediate connection segment between segments, such that the connection between one end of a segment with straight fins and one end of an adjacent segment with non-straight fins is direct. However, in a particular embodiment of the invention, between a segment with non-straight fins and an adjacent segment with straight fins, it is possible to have an intermediate connecting segment between two segments with fins, for example, for the purpose of adapting the winding path of the non-straight fins to the straight fins.

Likewise, it is established that the segment with non-straight fins of the at least one turbulator of the heat exchanger of the present invention comprises mainly a thermal footprint region, where the term "mainly" should be interpreted to mean that most of the thermal footprint region is inside the area covered by the segment with non-straight fins. The same occurs with the segment with straight fins, this segment comprises mainly a region outside the thermal footprint region, where the term "mainly" should be interpreted to mean that most of the area covered by the segment with straight fins is outside the thermal footprint region.

Therefore, in accordance with the preceding paragraph, it is possible for the segment with non-straight fins of the at least one turbulator of the heat exchanger of the present invention to extend beyond the thermal footprint region, such that the boundary between the segment with non-straight fins and the segment with straight fins is located spaced from the boundary delimiting the thermal footprint region and outside of said thermal footprint region.

Likewise, it is also possible for the segment with straight fins of the at least one turbulator of the heat exchanger of the present invention to extend towards the thermal footprint, with a part of the segment with straight fins being inside the thermal footprint region, such that the boundary between the segment with non-straight fins and the segment with straight fins is located spaced from the boundary delimitingthe thermal footprint region and inside said thermal footprint region.

These spacing conditions, according to the preferred examples, can be afforded both in the flow direction and in the transverse directions of the flow and both independently.

Preferably, the thermal footprint is rectangular with two sides parallel to the longitudinal direction and two sides perpendicular to the longitudinal direction.

Preferably, when the conduit has a configuration consisting of two flat walls parallel to and spaced from one another, it is formed by a flat wall for heat exchange with the heat source located in the external part of said wall and, an also flat cover or covering which is placed over the flat heat exchange wall, configuring the inner space of the conduit.

Preferably, the boundary between the segment with non-straight fins and the segment with straight fins of the at least one turbulator of the heat exchanger of the present invention is a straight line transverse to the longitudinal direction, the main flow direction; also preferably, the distances between the thermal footprint region and the boundary between the segment with non-straight fins and the segment with straight fins are measured in the longitudinal direction.

With respect to the at least one turbulator of the heat exchanger of the present invention, in a possible embodiment thereof, at least one segment with straight fins is arranged in a region completely outside the thermal footprint region, such that an adjacent non-straight fin section is arranged in a region containing at least one thermal footprint region and extends beyond the boundary of said thermal footprint region.

According to this embodiment, in those cases where the heat exchange footprint has a significant area of influence, it is possible to increase heat exchange by extending the region of the segments with non-straight fins, thereby favoring a more efficient heat discharge.

Preferably, in the at least one turbulator of the heat exchanger of the present invention, *according to the flow direction, between the boundary delimiting a thermal footprint region and the boundary delimiting the attachment of a segment with non-straight fins with an adjacent segment with straight fins of the turbulator or of a segment with straight fins with an adjacent segment with non-straight fins, there is a distance comprised by a transition area, wherein the boundary delimiting the attachment of a segment with non-straight fins with an adjacent segment with straight fins or vice versa:*
- *is outside the thermal footprint region, or*
- *is inside the thermal footprint region,*
*and wherein the distance of this transition area (i.e., the length in longitudinal direction X-X') is comprised between 1 and 15 mm, more preferably between 1 and 10 mm, more preferably between 1 and 5 mm, and more preferably between 1 and 2.5 mm.*

This transition segment allows the path of the curved channels, established by the fins of the segments with non-straight fins, to be adapted to the straight channels formed by the fins of the segments with straight fins. Preferably, when the non-straight paths are curved and winding paths, the point where the tangent to the curved path coincides with the direction of the straight channels is chosen such that there is continuity in the derivative of the path. In a winding path and following the flow direction, this condition of tangency is verified in the area where there is a maximum or a minimum, with the path being viewed as a function extending along the flow direction.

In this description, "boundary of the thermal footprint region" is interpreted to mean the perimeter line demarcating the thermal footprint region separating points which are located inside the thermal footprint and points located outside the thermal footprint.

As described above, according to a preferred embodiment, *the at least one conduit comprises a first wall corresponding to the heat exchange wall, a second wall spaced from the first wall, and side walls connecting the first and second walls. More preferably, the first and second walls of the at least one conduit are parallel to one another. More preferably, the distance between the respective inner faces of the first and second walls of the at least one conduit is less than or equal to 40 mm, preferably less than or equal to 30 mm, and more preferably less than or equal to 20 mm.*

This is a very compact configuration which establishes an inner configuration of the conduit which, according to a cross-section, presents a constant thickness. If the inner face of the first wall is furthermore flat, it allows the turbulator to have a flat configuration with thickness allowing the distance between the first wall and the second wall. Accordingly, the term "thickness" used in this application should in no case be understood to mean the thickness of the wall of the turbulator.

Preferably, the at least one turbulator comprises a plurality of different flow channels (i.e., more than one flow channel) which are distributed along a direction transverse to the flow direction, i.e., occupying the width of the turbulator, and each flow channel being separated from one another, such that there are formed in this turbulator configuration a plurality of divided flow paths distributed transversely and extended along the flow direction of the liquid coolant. According to this particular turbulator configuration in which there is a plurality of flow channels distributed according to the transverse direction and separated from one another, the segments with straight fins and the segments with non-straight fins preferably coincide along the flow direction for all the rows of fins.

Preferably, the at least one turbulator of the heat exchanger of the invention is arranged in a centered position between the side walls in which there is a respective bypass distance between each side wall and the turbulator. Preferably, said bypass distance is comprised between 0 and 20 mm, and more preferably a distance smaller than the width of the channels of the turbulator so as to favor the passage of the main flow through the inside of the channels in which the greatest heat exchange occurs. In the case of non-straight fins of wavy type, the bypass distance measured between the side edge of the fin and each respective side wall of the heat exchanger is variable (as a result of the effect of the wave of the fins). Therefore, in this application, "bypass distance" is understood to mean the minimum distance between the fin and the side wall of the conduit, i.e., the distance between a maximum (corresponding to the peak if it is a sine wave) of a wave of a non-straight segment with fins if viewed as a function in the longitudinal direction and the side wall.

*Preferably, the at least one turbulator comprises k different*/*differentiated segments with straight fins distributed along the flow direction and n different*/*differentiated segments with non-straightfins distributed along the flow direction. It is understood that the k different segments with straight fins and the n different segments with non-straight fins are intercalated with one another, such that a segment with straight fins is connected to a segment with non-straight fins and so on and so forth.*

*The applicant has verified that, the value of k is preferably comprised between 1 and 30.*

*The applicant has also verified that, the value of n can preferably be any of the three following values: (a) equal to k; (b) k* + 1; *or (c) k* - 1, *if k is greater than 1.*

The non-straight segments with fins have a greater capacity to exchange heat with the liquid coolant, and therefore they are suitable to be located on the thermal footprint region. In preferred examples, there can be a thermal footprint region or a plurality of thermal footprint regions. When there is a plurality of thermal footprint regions on which the turbulator has segments with non-straight fins, these segments with non-straight fins are connected by means of segments with straight fins such that the liquid coolant passes from a segment with non-straight fins to another contiguous segment also with non-straight fins in a guided manner through the segment with straight fins. It has been demonstrated that the entrainment forces generated by the straight fins, contrary to what was expected, give rise to a lower pressure drop than if a free space is left in between to prevent this entrainment effect, for example, by the presence of limiting layers on the surfaces of the fins. In other words, heat exchange is more efficient overall and a lower pressure drop is obtained.

When the value *n* (number of segments with non-straight fins) is equal to *k* (number of different segments with straight fins), the turbulator of the invention has at one of its ends, according to the flow direction, a segment with straight fins which favors the guiding of the flow also between the inlet and the turbulator, or between the turbulator and the outlet of the liquid coolant, where this end with the segment with straight fins is located.

When the value *n* is equal to *k* - 1, when *k* is greater than 1 (case "c"), then the distribution of segments of the turbulator of the invention according to the flow direction is such that two segments with straight fins are always located between a respective segment with non-straight fins, such that at both ends of the turbulator, according to the flow direction, there is a segment with straight fins, thereby favoring guiding when feeding the liquid coolant both from the inlet and to the outlet of the exchanger.

Lastly, when the value *n* is equal to *k* + 1, the turbulator of the invention has a distribution of segments according to the flow direction in which a segment with straight fins is located between two segments with non-straight fins, such that, in this case, at the ends of the turbulator there are always segments with non-straight fins located on the thermal footprint regions and positioned at the end along the flow direction. There are no parts of the turbulator between these two ends and the liquid coolant inlet or outlet.

*In a particular embodiment of the at least one turbulator of the invention, the turbulator comprises at least one segment with non-straight fins with a length L_{wn} along the flow direction comprised between 2 and 500 mm, preferably from 2 to 250 mm, and more preferably from 2 to 100 mm.*

*In a particular embodiment of the at least one turbulator of the invention, the turbulator comprises at least one segment with straight fins with a length Lₛₖ along the flow direction comprised between 2 and 500 mm, preferably from 2 to 250 mm, and more preferably from 2 to 100 mm.*

In a particular embodiment of the at least one turbulator of the invention, the turbulator has a length L_{wn} along the flow direction of each of the n segments with non-straight fins which is the same.

*In an alternative embodiment of the at least one turbulator of the invention, the turbulator has a length L_{wn} along the flow direction of at least one of the n segments with non-straight fins which is different from at least another one of the n segments with non-straight fins.*

*In a particular embodiment of the at least one turbulator, the turbulator has a length Lₛₖ along the flow direction of each of the k segments with straight fins which is the same.*

*In an alternative embodiment of the at least one turbulator, the turbulator has a length Lₛₖ along the flow direction of at least one of the k segments with straight fins which is different from at least another one of the k segments with straight fins.*

In a particular embodiment of the at least one turbulator, the turbulator has a total length Lₜₒₜₐₗ measured along the flow direction which is comprised between 1 and 1500 mm.

In a particular embodiment of the at least one turbulator, the turbulator has a width, calculated as the distance between the two farthest points in the transverse direction Y-Y', which is comprised between 500 mm and 15 mm, more preferably between 300 mm and 15 mm, and more preferably between 100 mm and 15 mm.

*In a particular embodiment of the at least one turbulator, and in the case where at least one segment with non-straight fins is of a wavy type, the attachment or connection between a straight fin section and an adjacent non-straight fin section occurs at a point of the wave of the segment with non-straight fins corresponding to a maximum or a minimum.*

The applicant has found that this attachment between a straight fin section and a non-straight fin section, adjacent to one another, at a point corresponding to a maximum or a minimum of the wave advantageously optimizes the continuous channel created for the passage of fluid in the attachment of both different segments with fins.

Likewise, according to an embodiment in which there are several segments with straight fins, at least two segments with straight fins have a different attachment, that is, one at a point corresponding to a maximum and another at a point corresponding to a minimum. According to this configuration, corresponding with a maximum means that the fins of the segment with straight fins are arranged closer to one of the sides of the conduit, reducing the side channel bypass, but leaving a larger passage channel on the other side.

The greater ease of passage of the liquid coolant on the side that leaves a larger passage channel is limited in a different position along the flow direction by the segment with straight fins which is attached at a point corresponding to a minimum since the fins of this segment is arranged closer to the side opposite the first side. The bypass flow is limited by "the bottleneck" or restriction imposed by the narrower passage, and therefore although it is in a position along the different flow direction, the restriction is the same on both sides, finally favoring the passage of the liquid coolant through the channels of the turbulator which exchange heat with the liquid coolant more efficiently. The distribution of the liquid coolant on the side by the bypass channels is similar insofar as the turbulator has an even number of straight segments, such that half are attached by a maximum and half by a minimum. In contrast, if the turbulator has an odd number of straight segments (for example, three: two connected by a maximum and one by a minimum) of the same length, distribution of the liquid coolant on the side by the bypass channels is not the same given that the channel having a smaller number of straight segments arranged closer to the side wall offers less flow resistance.

In a particular embodiment of the at least one turbulator, the at least one channel of the turbulator comprises, along the flow direction, at least one segment with straight fins, wherein each segment with straight fins is alternated with two segments with non-straight fins, such that each segment with straight fins is arranged in an intermediate position between two adjacent segments with non-straight fins along the flow direction.

*According to a possible example of the heat exchanger, the arrangement of non-straight segments and straight segments of the at least one turbulator of the heat exchanger of the present invention is such that it is invariable with respect to a 180*º *rotation according to an axis perpendicular to the heat exchange wall.* This advantageous configuration with the same geometry (i.e., with the same position of the turbulator) allows preventing errors when the operator assembles the turbulator in the heat exchanger. If the preceding condition is not met, there is the risk of the turbulator being assembled in two different orientations in the exchanger, giving rise to two different parts.

Preferably, it is of interest that the number of segments with non-straight fins in the turbulator is greater than the number of segments with straight fins.

Preferably, the number of segments with straight fins in the turbulator is an even number, because in the case of an odd number, the condition of the geometry being invariable upon rotating it 180ºC with respect to the axis perpendicular to the heat exchange wall cannot be met because, unlike a segment with non-straight fins, the segment with straight fins is arranged closer to one side or to the opposite side, but one and the same segment with straight fins cannot be arranged closer to all two sides, which is what would be required in the center.

According to a specific possible example of the heat exchanger, the at least one turbulator comprises three segments with non-straight fins and two segments with straight fins, connected to one another continuously, with a segment of each type being intercalated along the flow direction, giving rise to the following configuration of five continuous segments in this order: a first segment with non-straight fins at one end, a first segment with straight fins, a second segment with non-straight fins, a second segment with straight fins, and a third segment with non-straight fins at the opposite end.

*According to a possible example of the heat exchanger, the heat exchanger comprises a turbulator comprising a plurality of segments with straight fins, and preferably three segments with non-straight fins, and wherein each segment with non-straight fins is formed by wavy fins with a wave formed by: (a) straight segments, preferably a square wave, or (b) with a curved wave, preferably a sine wave, and wherein:*
- *at least a first segment with straight fins presents an attachment with the segment with non-straight fins in a maximum of the wave;*
- *at least a second segment with straight fins, different from the first segment, presents an attachment with the segment with non-straight fins in a minimum of the wave; such that the first segment with straight fins is shifted with respect to the second segment with straight fins in the direction transverse to the flow to restrict the passage between the turbulator and the conduit on either side of the turbulator.*

Preferably, the turbulator of the heat exchanger is formed by a single metal sheet, which extends in the longitudinal direction X-X' following a configuration determined by the flow direction, and which can also extend according to a direction Y-Y' transverse to direction X-X'.

Preferably, said single metal sheet can be formed by a stamping process, although other manufacturing means are possible.

Preferably, possible attachment means for attaching the structure of the turbulator to the inner surface of the conduit of the heat exchanger is welding, brazing, adhesion, or other similar attachment methods.

In a second inventive aspect, the present invention provides *a heat exchanger module comprising at least:*
- *one heat exchanger as defined above in any of the possible embodiments that have been described, wherein the heat exchanger comprises, on the inside of the at least one conduit, a turbulator such as the one described in any of the examples, wherein the segments with non-straight fins are located on the thermal footprint region of at least one external element or component; and*
- *at least one external element or component to be cooled or heated, such as a battery cell or an electric or electronic component, placed outside the conduit of the heat exchanger, and the at least one external element or component occupying a heat exchange region close to or in contact with the wall of the at least one conduit of the heat exchanger.*

### DESCRIPTION OF THE DRAWINGS

These and other features and advantages of the invention will be shown more clearly based on the following detailed description of a preferred embodiment, provided solely by way of illustrative and non-limiting example in reference to the attached figures.
Figure 1A shows a perspective view of an embodiment of the heat exchanger according to the invention.
Figure 1B shows a perspective view of the same embodiment of the heat exchanger, in which the upper cover has been removed to allow viewing the inside of the heat exchanger.
Figure 2A shows a bottom plan view of the same embodiment of the heat exchanger of the invention.
Figure 2B shows a top plan view of the same embodiment of the heat exchanger of the invention with the cover removed as shown in Figure 1B.
Figure 2C shows a top plan view of the same embodiment of the heat exchanger of the invention with the upper cover as shown in Figure 1A.
Figure 3A-3B show the same views as Figures 2A and 2B, in which rectangles identifying the thermal footprint of an external electric or electronic element or component has been superimposed on the heat exchanger, but in which the external element or component is not shown.
Figure 3C is an enlarged Figure 3B in which several relevant parameters of a specific design are further included depending on the extension of the segments with straight and non-straight fins.
Figure 3D is an alternative of Figure 3C, in which the rectangles identifying the thermal footprint of an external electric or electronic element or component extend beyond the segments with non-straight fins.
Figure 4 shows a cross-section of the heat exchanger according to the same embodiment.
Figure 5 shows two heat exchangers according to the preceding examples arranged opposite one another for cooling the same external electric or electronic elements or components located interposed between the heat exchangers.
Figure 6 shows a second embodiment of heat exchangers in which the central plate is not intended for heat transfer, but the surfaces acting as an upper and lower covers are.
Figure 7 shows a plurality of heat exchangers according to the first embodiment, stacked such that the external electric or electronic elements or components are interposed, and in which the heat exchangers drain heat through the main plate and through the cover.
Figure 8 shows a plurality of heat exchangers according to the second embodiment, stacked such that the external electric or electronic elements or components are interposed, and in which the heat exchangers drain heat through the upper and lower covers.

### DETAILED DESCRIPTION OF THE INVENTION

According to the first inventive aspect, the present invention relates to a heat exchanger device (1), preferably suitable for cooling one or more external electric or electronic elements or components with respect to the exchanger, such as one or more semiconductor devices (D) intended for switching, amplifiers, etc.

These electric or electronic elements or components have extremely demanding cooling requirements since the thermal energy to be discharged is very high and must be discharged through a very small contact surface.

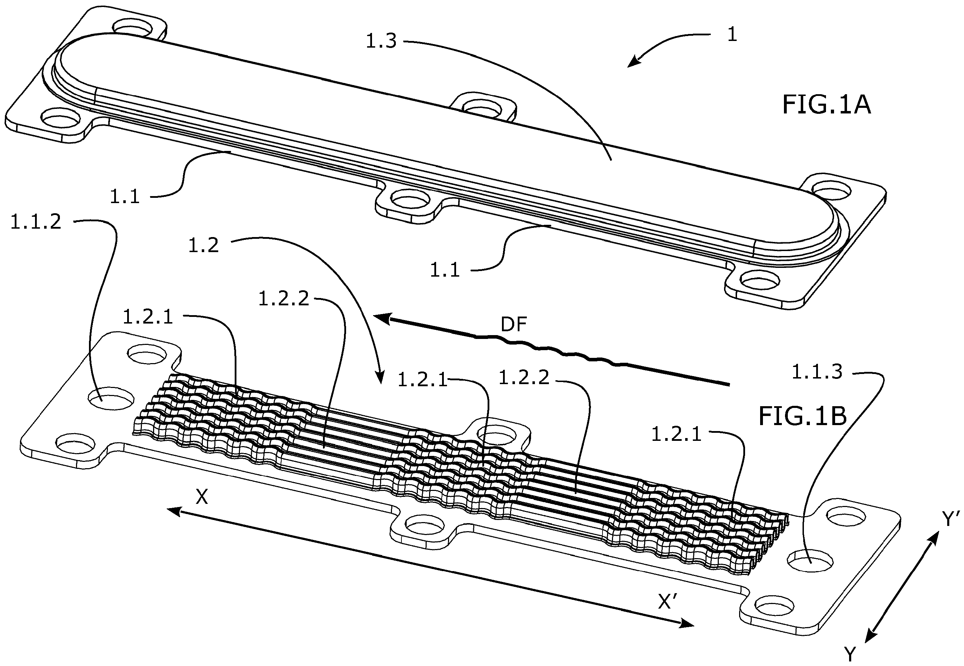

According to a first aspect of the invention, the embodiment of the heat exchanger (1) is shown in its assembled configuration seen in a perspective view in Figure 1A. This example of heat exchanger (1) has an essentially flat configuration and comprises a flat metal plate which, in this example, serves as a heat exchange wall (1.1) because the electric or electronic device or devices (D) (not shown in this first Figure 1A) are located close to or in contact with the outer surface of this flat plate on the side opposite where the upper cover (1.3) is located.

According to the orientation shown in Figure 1A, the lower surface is located on the upper surface of a plurality of electric or electronic devices (D) to be cooled. In this illustrated embodiment, there are three electric or electronic devices (D) to be cooled.

As seen in Figure 1A, a plate-like cover (1.3) is arranged in the upper part of the heat exchanger (1), placed over the heat exchange wall (1.1), thereby closing an inner space intended for the passage of a liquid coolant. This inner space constitutes the conduit of the heat exchanger (1).

When viewed from the top, the cover (1.3) has an external shape that is substantially the same as the shape of the heat exchange wall (1.1) because it covers most of the area of the heat exchange wall (1.1).

In Figure 1B, the upper cover (1.3) has been removed in order to allow viewing the inner space of the heat exchanger (1). In particular, the presence of a turbulator (1.2) intended for enhancing heat transfer between the liquid coolant (not depicted) flowing according to the flow direction (DF) represented by a thick arrow is observed, and wherein the liquid coolant exchanges heat with the external electronic component(s) (D), in this particular example through the heat exchange wall (1.1).

According to this embodiment, this turbulator (1.2) is formed by a single metal sheet formed by stamping. This sheet extends in the longitudinal direction X-X' following a configuration determined by the flow direction (DF) and also according to a direction Y-Y' transverse to the longitudinal direction X-X'. This thick arrow is slightly wavy in a central area denoting that the flow follows a wavy path in a central segment under which the arrow is located. In this specific case, taking into consideration the longitudinal path X-X', the turbulator (1.2) has three segments with wavy fins (1.2.1), wherein two adjacent segments with wavy fins (1.2.1) are connected by an intermediate segment with straight fins (1.2.2).

Now, taking into consideration a cross-section of the turbulator (1.2), all the sections have a wavy configuration. In this embodiment, the turbulator (1.2) is obtained from a metal sheet which is configured in the described shape by deformation.

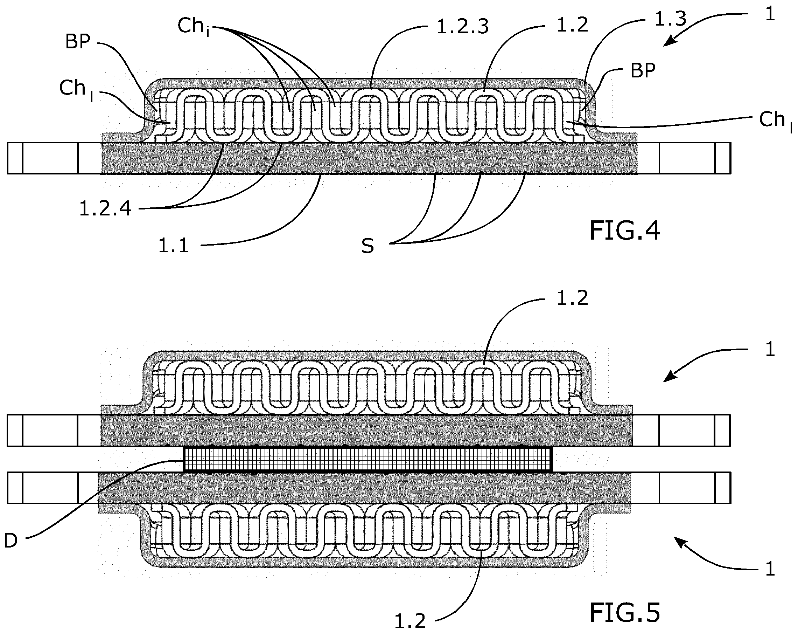

Figure 4 shows the cross-section of the heat exchanger (1) in which it can be seen that, in this illustrated embodiment, the wave is configured as a square wave, with the corners of the square wave being rounded. Therefore, the wavy cross-section shows straight segments both in the upper ridges (1.2.3) and in the lower ridges (1.2.4).

The straight segments of the lower ridges (1.2.4) rest on the inner surface of the heat exchange wall (1.1) and the upper ridges (1.2.3) are supported on the inner surface of the cover (1.3). According to this embodiment, the attachment between the turbulator (1.2) and the cover (1.3) and the attachment between the turbulator (1.2) and the heat exchange wall (1.1) are carried out by brazing in the contact regions, mainly through the areas of the turbulator (1.2) which correspond with the straight segments that have been described.

Therefore, as shown in Figure 4, a conduit having an essentially rectangular section is generated between the cover (1.3) and the heat exchange wall (1.1), where the heat exchange wall (1.1) is the plate which, in the figures shown in perspective views, is oriented as the lower wall, the cover (1.3) completes the flat upper surface and furthermore extends laterally, giving rise to vertical side walls, i.e., perpendicular to the heat exchange wall (1.1) if horizontal is taken as reference.

The turbulator (1.2) is therefore housed in the space generated by the heat exchange wall (1.1) and the cover (1.3), causing the presence of passage channels. The fluid is forced to flow following the inner channels (Chi) defined by the turbulator (1.2) plus the two side channels (*Chₗ*).

In this same Figure 4 in which the projection of the fins according to the longitudinal direction is observed, it is possible to distinguish the restriction of the side channels (*Chₗ*) depending on whether the straight segments are arranged closer to the right or to the left, leaving a narrower bypass channel (BP) projecting according to the longitudinal direction.

Returning to Figure 1B, it is observed that the inner fluid channels configured in the turbulator (1.2) are mainly oriented according to the longitudinal direction X-X', which is the main fluid flow direction. The term "mainly" is used because in the segments with non-straight fins in this embodiment the flow of the coolant fluid follows an undulating winding path, although it typically moves according to the longitudinal direction X-X'.

The fluid flow has an inlet/outlet (1.1.2) in the form of a perforation in the heat exchange wall (1.1) located in an area close to the end, and an outlet/inlet (1.1.3) also in the form of a perforation in the heat exchange wall (1.1) located in an area close to the end opposite the inlet/outlet (1.1.2).

The notation inlet/outlet or outlet/inlet indicates that the perforations allow flow in both directions such that, when one perforation acts as an inlet, the other acts as an outlet, so the option before the slash "/" would be considered, and for flow in the opposite direction, the option located on the right side of the slash "/" would be considered.

The two perforations are in an area close to the end of the heat exchanger (1) but they coincide with the inner space demarcated by the cover (1.3). For that reason, in this embodiment, the ends of the cover (1.3) have a rounded termination, according to the top view configuration.

According to the longitudinal direction X-X', it is also observed that the turbulator (1.2) shows segments where the wave extends longitudinally in a sinusoidal configuration, i.e., a wavy configuration, also in the longitudinal direction, and a segment where the fins extend longitudinally according to a straight configuration. These two different segments of the turbulator (1.2) are identified as segment with non-straight fins (1.2.1) and segment with straight fins (1.2.2), respectively.

According to the configuration show in Figure 1B, the turbulator (1.2) has five different segments with fins, of which three are segments with non-straight fins (1.2.1) and two are segments with straight fins (1.2.2), each segment with straight fins (1.2.2) being intercalated between two adjacent segments with non-straight fins (1.2.1). This Figure 1B shows the five segments with fins arranged consecutively in an alternating manner, as described.

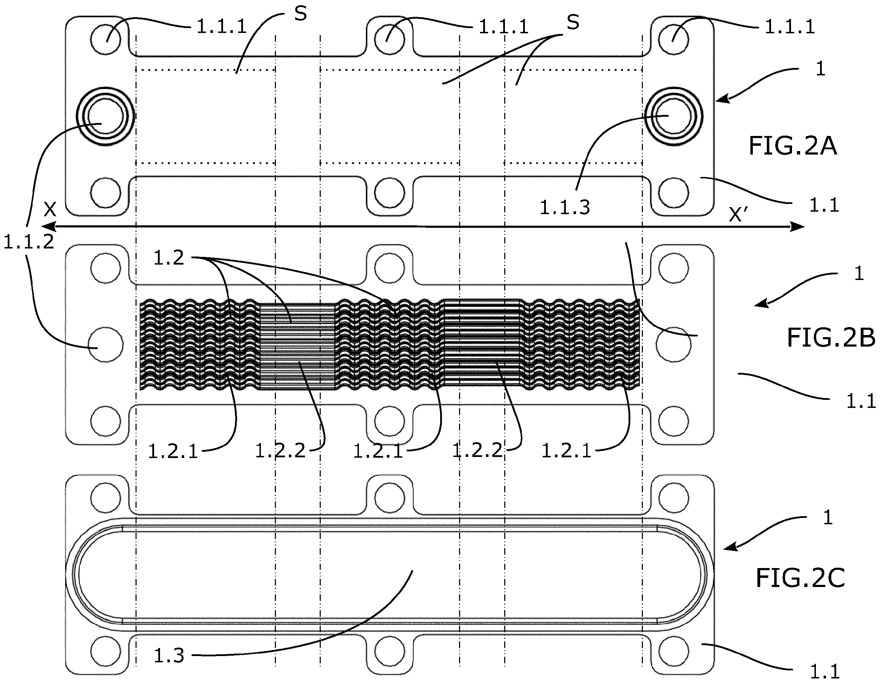

Figure 2A is a bottom plan view of the same heat exchanger (1) as Figures 1A and 1B, in which the outer surface of the heat exchanger (1), which is in thermal contact with the heat sources (not shown in this Figure 2A), is shown.

This bottom plan view shows the plate giving rise to the heat exchange wall (1.1) extending along the perimeter by means of fixing prolongations (1.1.1). The same figure, not including references, shows other means which allow the fixing of the plate, and by extension, of the heat exchanger as a whole. Fixing means are perforations for the passage of threaded stud bolts or passages in the form of open grooves which also allow the passage of threaded stud bolts but with greater positional play.

This bottom view shows inlet/outlet port (1.1.2) for the liquid coolant and the outlet/inlet port (1.1.3) also for the liquid coolant.

Figure 2A also depicts three rectangular regions, separated from one another, which are identified with the letter "S" and correspond to an area configured mainly for receiving one or more external electric or electronic devices (D). This area does not have to be completely occupied by the semiconductor device, as it will depend on the specific application. However, once the semiconductor device is in thermal contact with the heat exchange wall (1.1) in this area (S) for receiving one or more external electric or electronic devices (D), the configuration and shape of the thermal footprint region (H) is defined. Therefore, the thermal footprint region (H), according to a projection perpendicular to the heat exchange wall (1.1), will always occupy an area inside the area (S) for receiving one or more external electric or electronic devices (D).

The area (S) for receiving one or more external electric or electronic devices (D) allows the surface of the heat exchange wall (1.1) and the outer surface of the electric or electronic device (D) to be cooled to be attached using intermediate substances.

According to one embodiment, this intermediate substance is an adhesive which secures the close attachment between the surfaces to be attached. According to another embodiment, the intermediate substance is a paste with high coefficient of thermal conduction in order to favor heat transfer from the electric or electronic device (D) to the heat exchange wall (1.1).

As indicated, the area (S) for receiving one or more external electric or electronic devices (D) does not have to coincide with the configuration of the surface to be cooled. In this embodiment, the size of each rectangular region consisting of the area (S) for receiving one or more external electric or electronic devices (D) is larger than the surface to be cooled. Among other advantages, it prevents positional errors from hindering the coincidence of the surface (S) for receiving one or more external electric or electronic devices (D) with the surface to be cooled.

Additionally, using areas (S) for receiving one or more external electric or electronic devices (D) of a larger size than the areas to be cooled allows the same heat exchanger (1) to be valid for different configurations of devices (D) to be cooled, allowing a plurality of configurations to coincide at all times with the areas (S) for receiving one or more external electric or electronic devices (D).

Figure 2B is a top plan view of the heat exchanger (1) after removing the cover (1.3) to facilitate viewing the inside of the turbulator (1.2). Figures 2A, 2B, and 2C are aligned for the purpose of cross-referencing the positions of the areas (S) for receiving one or more external electric or electronic devices (D), the segments with non-straight fins (1.2.1), and the segments with straight fins (1.2.2). In this embodiment, it is observed that the length (in the direction X-X') of the areas (S) for receiving one or more external electric or electronic devices (D) is greater than the length of the corresponding areas in which the segments with non-straight fins (1.2.1) are located.

In this case, "corresponding" areas is used to establish a comparison of the area on a surface and the area on the opposite surface of the heat exchange wall (1.1) projecting according to a direction perpendicular to said wall (1.1).

Figures 2A to 2C allow observing that, in this embodiment of the invention, three pairs of fixing holes (1.1.1) are envisaged, two pairs at the ends and one pair in the central area.

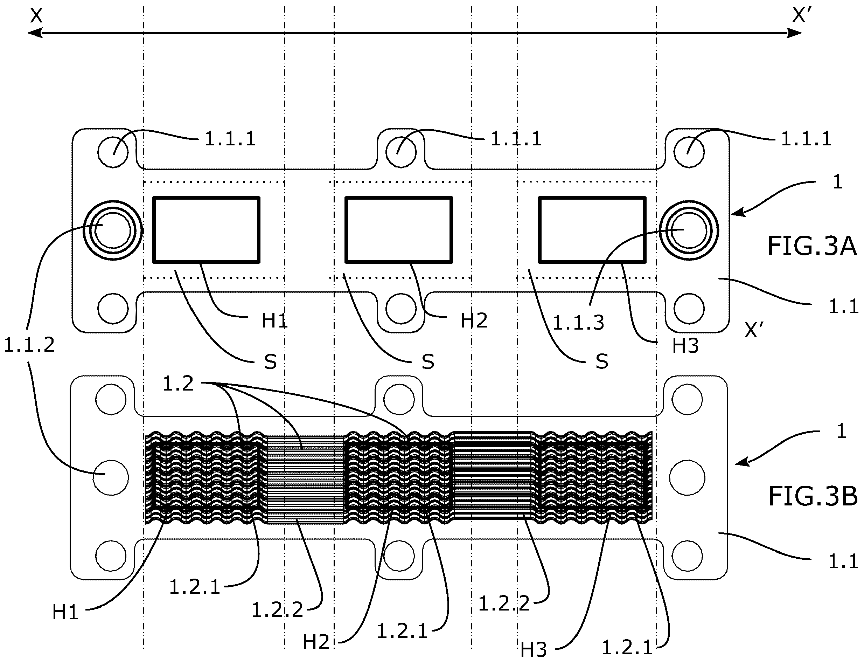

Figure 3A and 3B correspond to the same Figures 2A and 2B, respectively, in which a rectangle drawn with a continuous line has been superimposed over each segment with non-straight fins (1.2.1). Each rectangle drawn with a continuous line, identified with the letter "H", represents the thermal footprint of the electric or electronic device (D) to be cooled and which is in contact with the heat exchange wall (1.1).

Each electric or electronic device (D) to be cooled is in thermal communication through a contact region which, in this embodiment, is established in the area (S) for receiving one or more external electric or electronic devices (D). In the region where thermal contact is established, heat transfer occurs, preferably from the electric or electronic device (D) to the conductive body formed by the heat exchange wall (1.1). The greater the thickness of the heat exchange wall (1.1), the greater heat diffusion will be in the direction of the main plane of the heat exchange wall (1.1).

Preferably, the heat exchange wall (1.1) is formed from a metal sheet to facilitate heat transfer from the area (S) for receiving one or more external electric or electronic devices (D) to the opposite surface by conduction. The opposite surface is the surface on which the turbulator (1.2) is arranged.

There is an area on the opposite surface in which heat transfer increases the temperature. Although the diffusion effect means that the area of influence is greater than the area in which heat transfer occurs by contact with the electric or electronic device (D), the perimetral region of the region of influence shows a temperature gradient blurring the limit of the region of influence.

However, while this is the case, when the thermal footprint (H) is identified, the footprint given by the projection according to the direction perpendicular to the heat exchange wall (1.1) of the area corresponding to the heat source, for example a semiconductor, in contact with the opposite or outer surface, is taken as reference. In other words, if the contact region with the electric or electronic device (D) in which heat transfer to the heat exchange wall (1.1) occurs is a rectangle, the thermal footprint (H) on the opposite surface will be the same rectangle, with the same dimensions, represented on the opposite surface according to the projection given by the direction perpendicular to the wall (1.1).

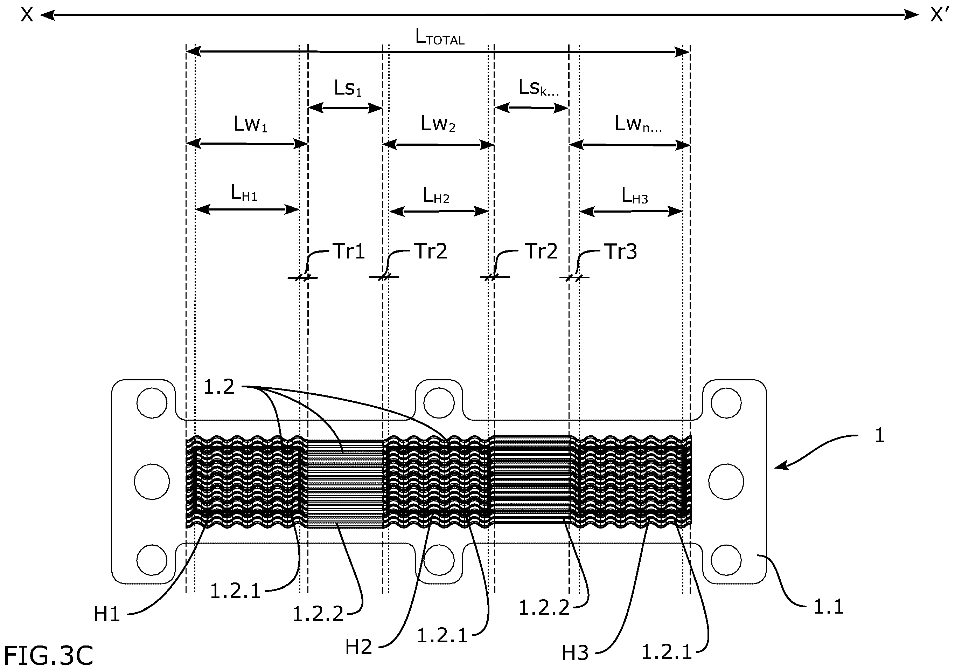

Figures 3A, 3B, and 3C show one and the same embodiment of the invention in which the thermal footprints (H) are contained entirely inside the regions with non-straight fins (1.2.1) given that, when there are non-connected regions in which heat exchange must be increased, it is in those areas in which the convection phenomena of the liquid coolant must be favored to thereby increase the cooling capacity of the heat exchanger. For this reason, the segments of the turbulator (1.2) which are located covering the thermal footprint (H) are not straight; in this embodiment, they are wavy according to the longitudinal direction X-X'. This wavy configuration favors the emergence of turbulence or at least increases the value of coefficient of convection, thereby reducing the thermal resistance of the heat exchange.

According to the teachings of the state of the art, the regions that do not have to be cooled preferably cause the lowest pressure drop possible and this is achieved by leaving the passage of the liquid coolant free of surfaces causing the deflection thereof or the emergence of limiting layers which generate an entrainment effect, and therefore cause a pressure drop.

Contrary to this preconception, it has been found that the inclusion of segments with straight fins (1.2.2) located between segments with non-straight fin (1.2.1), instead of causing a greater pressure drop, has been observed to give rise to a lower pressure drop. In particular, segments with straight fins (1.2.2) were used such that the channels formed by the fins of the segments with non-straight fins (1.2.1) show continuity with the channels formed by the segments with straight fins (1.2.2).

Likewise, in this embodiment, the configuration of the wavy fluid path according to the longitudinal direction of the non-straight fins (1.2.1) is such that transition with the segment with straight fins (1.2.2) is established where the tangent of the wavy path of the walls of the channel is parallel to the longitudinal direction X-X'.

It has been proven that the existence of a segment with straight fins (1.2.1), in addition to favoring a lower pressure drop, gives rise to greater structural rigidity of the heat exchanger (1), particularly the flexural rigidity of the main plane of the heat exchange wall (1.1).

According to the first embodiment shown in Figures 1 to 3C, the three differentiated thermal footprint regions (H1, H2, H3) are located entirely inside the respective segment with non-straight fins (1.2.1). In this first embodiment, see Figure 3C, it is observed that each segment with non-straight fins (1.2.1) covers an area greater than the respective thermal footprint region (H), taking into consideration both the longitudinal direction X-X' and the transverse direction.

The boundary between each segment with non-straight fins (1.2.1) and segment with straight fins (1.2.2) of the turbulator (1.2) has been indicated in Figure 3C with a straight transverse discontinuous line. Likewise, the ends or boundaries according to the longitudinal direction of the thermal footprint region (H) have also been indicated with a straight transverse dotted line, in this case, the smaller sides of the rectangle representing the region.

Therefore, both boundary straight lines are shown parallel to and spaced from one another, giving rise to a transition region (Tr) between said two straight lines. In the specific case of the first embodiment shown in Figures 1 to 3C, said transition regions (Tr) are formed by non-straight fins, and therefore part of the segment with non-straight fins (1.2.1).

In this first embodiment shown in the Figure 3C, the distance between both parallel boundaries, i.e., the distance of the transition region, is identified as Tr1, Tr2, and Tr3 for lengths of the thermal footprint region (H) also identified as L_{H1}, L_{H1}, and L_{H3}.

The length L_{wn} in the longitudinal direction X-X' of each segment with non-straight fins (1.2.1) is greater than the length in the longitudinal direction X-X' of the respective thermal footprint (L_{H1}, L_{H2}, L_{H3}), and there is a respective transition area (Tr) between the respective ends of each thermal footprint (H) with the transverse line of transition between a segment with straight fins and a segment with non-straight fins, wherein said respective transition area (Tr) is located inside the respective segment with non-straight fins (1.2.1). In this first embodiment of the invention, it is also observed that the length L_{wn} in the longitudinal direction X-X' of each of the three segments with non-straight fins (1.2.1) is slightly greater compared to the length Lₛₖ of each of the two segments with straight fins (1.2.2). In this case, the length of all the segments with non-straight fins (1.2.1) is the same and the length of all the segments with straight fins (1.2.2) is also the same.

Preferably, when the fins of the segment with non-straight fins (1.2.1) have a wavy or periodic configuration, the distance of the transition region Tr1, Tr2, Tr3 is such that the path of the waves reaches a maximum or a minimum, meaning that the tangent to the path (viewed in a plane parallel to the plane of the heat exchange wall (1.1)) is parallel to the longitudinal direction X-X'.

In this same Figure 3C, it is observed that the segment with non-straight fins (1.2.1), located further left in the figure, establishes tangency in a minimum (valley) of the wave, with all the channels formed by the segment with straight fins (1.2.2) thereby being arranged closer to the lower part of the figure. In contrast, the segment with non-straight fins (1.2.1), located further right in the figure, establishes tangency in a maximum (peak) of the wave, with the channels formed by the segment with straight fins (1.2.2) thereby being arranged closer to the upper part, i.e., on the opposite side according to the transverse direction. The term "minimum" or "maximum" in reference to the end positions of the wave corresponds to the orientation determined by the figure.

When the entire segment with non-straight fins (1.2.1) is arranged closer to one side, it approaches the side wall of the conduit and the width of the bypass channel (BP) is reduced. Since one segment is arranged closer to one side and the other segment closer to the other side, passage to the two bypass channels (BP) located on the end sides is simultaneously restricted overall.

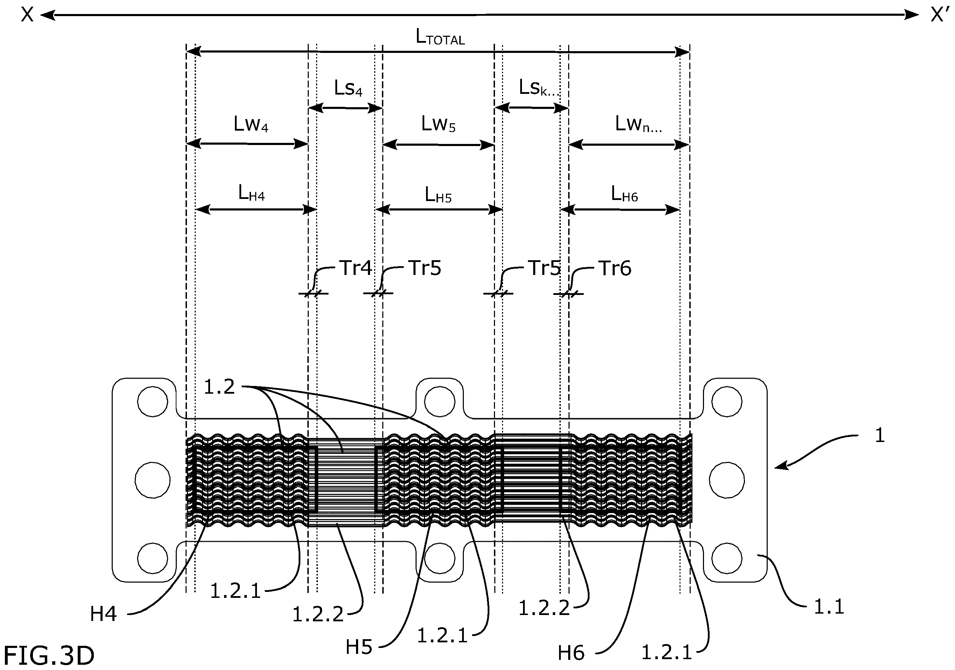

According to a second embodiment of the invention shown in Figure 3D, the three thermal footprints (H4, H5, H6) are located slightly to the inside, with at least one of their two sides being located in an adjacent segment with straight fins (1.2.2). In this second example, as shown in detail in Figure 3D, there is a respective transition area (Tr) between the respective ends of each thermal footprint (H4, H5, H6) with the transverse line of transition between a segment with straight fins and a segment with non-straight fins, wherein said respective transition area (Tr) is located inside the respective segment with straight fins (1.2.2).

Figure 4, already described above, shows a section view the plate configuring the heat exchange wall (1.1) on which the at least one turbulator (1.2) of the heat exchanger of the present invention is located. There is arranged, covering the turbulator (1.2) obtained by stamping to produce a one-piece part, the cover (1.3) which is supported on the upper ridges of the turbulator (1.2) and laterally closes the inner space in which the turbulator (1.2) is arranged for the passage of the liquid coolant. The attachment between the cover and the heat exchange wall (1.1) is carried out preferably by brazing, extending the perimetral edge below the walls of the cover so that it is located parallel to the heat exchange wall (1.1). The passage of fluid through the intermediate channels and the passage of fluid through the two end channels can be seen in this section. In heat exchangers having limitations for closing the sides, these end channels can give rise to preferred passages which give rise to a lower pressure drop, causing most of the liquid coolant flow to pass through the sides and not through the central channels that indeed have cooling capacity. In the configuration according to the invention, given that the presence of segments with fins having straight channels (1.2.2) is always combined with segments with fins having non-straight channels (1.2.1), the latter always have points that are arranged closer to the side walls to a greater extent, preventing this fluid leakage effect.

In this embodiment, as shown in Figure 5, the configuration with the flat surface of the heat exchange wall (1.1) advantageously allows using two different heat exchangers (1) such as the one described above which are positioned opposite one another, such that the area (S) for receiving one or more external electric or electronic devices (D) are facing one another, and the electric or electronic devices (D) to be cooled are located like a sandwich interposed between both heat exchangers (1). In this configuration, the fixing seats (1.1.1) of both heat exchangers (1) also coincide, so the pressure of one heat exchanger (1) against the other heat exchanger (1), and leaving the devices (D) to be cooled pressed, is achieved by simply establishing a screwed attachment between the two heat exchangers (1). This configuration is particularly effective when the electric or electronic devices (D) to be cooled have a flat configuration and allow heat to be discharged through the two surfaces demarcating said flat configuration.

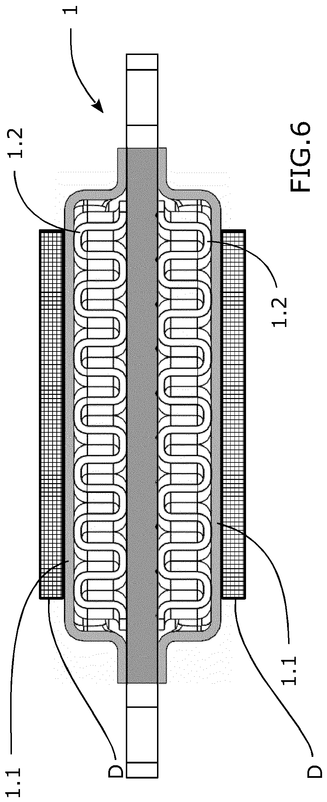

Figure 6 shows a second embodiment of a heat exchanger (1), in which there is incorporated in a flat plate a turbulator (1.2) on both sides of the plate covered by a cover. In this case, the cover acts as the heat exchange wall (1.1), such that in this case the heat exchanger (1) is interposed between two electric or electronic devices (D) to be cooled. The heat exchanger (1), according to this configuration, works such that it removes heat from the electric or electronic devices (D) which are located on both sides in thermal contact with the surfaces of the cover having a heat exchange wall (1.1) and cover a space with the plate, housing therein the turbulator (1.2). In this embodiment, each heat exchange wall (1.1) is in correspondence with a turbulator (1.2) comprising non-straight segments (1.2.1) for cooling the heat exchange wall (1.1) having the thermal footprint, and straight segments (1.2.2) connecting the non-straight segments (1.2.1) of the same shape which has been described for the first embodiment.

The electric or electronic devices (D) to be cooled are shown in Figure 5 below according to a hashed rectangle given that the section has been made to coincide with the position thereof according to the longitudinal direction X-X', and therefore also coinciding with the non-straight segment (1.2.1).

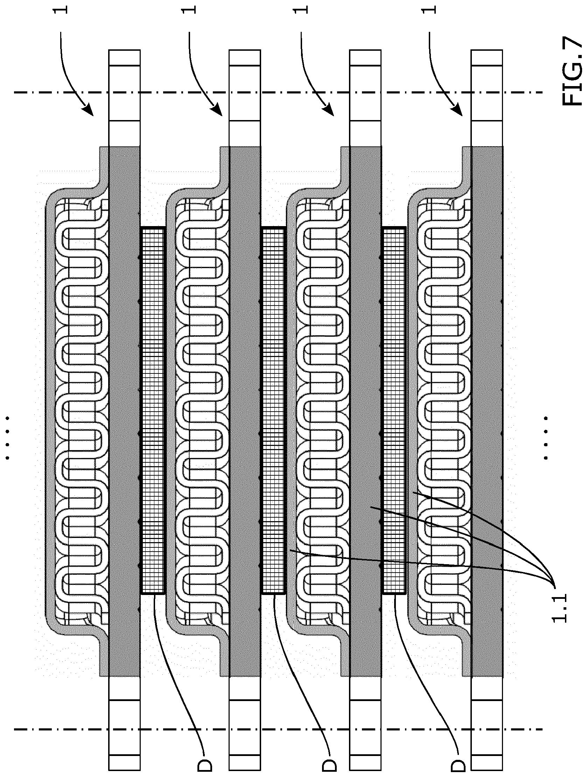

Figure 7 shows an embodiment of the heat exchanger formed by stacking the heat exchangers (1) according to the first embodiment and the devices (D) to be cooled. In this case, heat is discharged through the thicker flat plate and also through the cover, wherein both parts are now heat exchange walls (1.1). With this configuration, attachment means, for example, threaded stud bolts, which compress the stack to favor mutual contact between the heat exchangers (1) and the devices, increasing the thermal conductivity of the contact, can be used.

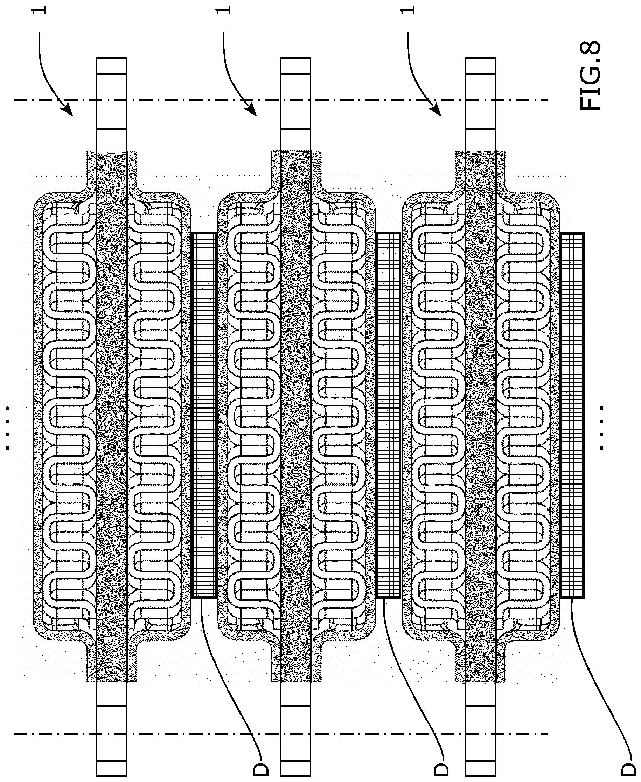

Lastly, Figure 8 shows a new stack using heat exchangers (1) according to the second embodiment, wherein both covers of this symmetrical configuration with respect to the central plate are now the heat exchange wall (1.1).

## Claims

1. Heat exchanger (1) comprising:
- at least one conduit adapted to allow the flow of a coolant fluid from a coolant fluid inlet cross-section to a coolant fluid outlet cross-section, the conduit comprising at least one heat exchange wall (1.1), wherein the exchange wall (1.1) comprises at least one region on its outer surface configured for being in thermal contact with at least one external element or component, the heat exchange region on the outer surface of the heat exchange wall having a corresponding thermal footprint region (H) on the inner surface of the heat exchange wall (1.1), wherein the thermal footprint region (H) corresponds to the projection of the region of the outer surface of the exchange wall (1.1) configured for being in thermal contact with at least one external element or component, or a group thereof, according to the direction perpendicular to the exchange wall (1.1);
- at least one turbulator (1.2) placed inside the at least one conduit to increase heat exchange, wherein the at least one turbulator (1.2) extends along the flow direction (DF) of the coolant fluid;
wherein the at least one turbulator (1.2) further comprises at least one flow channel through which coolant fluid flows in the flow direction (DF), wherein the at least one flow channel comprises at least one segment with fins (1.2.1) which are not straight in the flow direction and at least one segment with fins (1.2.2) which are straight in the flow direction, wherein
the at least one segment with non-straight fins (1.2.1) and the at least one segment with straight fins (1.2.2) are arranged in adjacent positions and distributed along the flow direction (DF),
the at least one flow channel of the segment with non-straight fins (1.2.1) is connected continuously along the flow direction (DF) with the corresponding flow channel of the adjacent segment with straight fins (1.2.2), such that a continuous flow path of the coolant fluid along the flow direction (DF) is configured,
each segment with non-straight fins (1.2.1) comprises mainly a thermal footprint region (H) to improve heat exchange, and
each segment with straight fins (1.2.2) comprises mainly a region outside of any thermal footprint region (H) to reduce pressure drop.

2. Heat exchanger (1) according to any of the preceding claims, wherein in the at least one turbulator (1.2) according to the flow direction (DF), between the boundary delimiting a thermal footprint region (H) and the boundary delimiting the attachment of a segment with non-straight fins (1.2.1) to an adjacent segment with straight fins (1.2.2) or of a segment with straight fins (1.2.2) to an adjacent segment with non-straight fins (1.2.1) there is a distance (d) comprised by a transition area (Tr), wherein the boundary delimiting the attachment of a segment with non-straight fins (1.2.1) to an adjacent segment with straight fins (1.2.2) or vice versa:
- is outside the thermal footprint region (H), or
- is inside the thermal footprint region (H),
and wherein the distance (d) of the transition area (Tr) is comprised between 1 and 15 mm, more preferably between 1 and 10 mm, more preferably between 1 and 5 mm, and more preferably between 1 and 2.5 mm.

3. Heat exchanger (1) according to any of the preceding claims, wherein at least one segment with non-straight fins (1.2.1) is a segment with fins selected from one of the following types: (a) wavy fins with a triangular profile or rounded profile or (b) fins offset in the flow direction.

4. Heat exchanger (1) according to any of the preceding claims, wherein the at least one conduit comprises a first wall (1.1) corresponding to the heat exchange wall, a second wall (1.3) spaced from the first wall, and side walls connecting the first and second walls.

5. Heat exchanger (1) according to the preceding claim, wherein the first wall (1.1) and the second wall (1.3) of the at least one conduit are parallel to one another.

6. Heat exchanger (1) according to the preceding claim, wherein the distance between the respective inner faces of the first wall (1.1) and the second wall (1.3) of the at least one conduit is less than or equal to 40 mm, preferably less than or equal to 30 mm, and more preferably less than or equal to 20 mm.

7. Heat exchanger (1) according to any of the preceding claims, wherein the at least one turbulator (1.2) comprises *k* segments with straight fins (1.2.2) distributed along the flow direction (DF), wherein *k* is comprised between 1 and 30.

8. Heat exchanger (1) according to any of the preceding claims, wherein the at least one turbulator (1.2) comprises *n* segments with non-straight fins (1.2.1) distributed along the flow direction (DF) and *k* segments with straight fins (1.2.2) distributed along the flow direction (DF), wherein *n* is:
equal to *k*,
*k* + 1, or
*k* - 1, if *k* is greater than 1.

9. Heat exchanger (1) according to any of the preceding claims, wherein the at least one segment with non-straight fins (1.2.1) of the turbulator (1.2) has a length *L_{wn}* along the flow direction comprised between 2 and 500 mm, preferably from 2 to 250 mm, and more preferably from 2 to 100 mm.

10. Heat exchanger (1) according to any of the preceding claims, wherein the at least one segment with straight fins (1.2.2) of the turbulator (1.2) has a length *Lₛₖ* along the flow direction comprised between 2 and 500 mm, preferably from 2 to 250 mm, and more preferably from 2 to 100 mm.

11. Heat exchanger (1) according to any of the preceding claims, wherein the arrangement of one or more non-straight segments with fins (1.1.1) and one or more straight segments with fins (1.2.2) of the at least one turbulator (1.2) is such that it is invariable with respect to a 180º rotation according to an axis perpendicular to the heat exchange wall (1.1).

12. Heat exchanger (1) according to any of the preceding claims, wherein the at least one turbulator (1.2) comprises 3 segments with non-straight fins (1.2.1) and 2 segments with straight fins (1.2.2).

13. Heat exchanger (1) according to any of the preceding claims, wherein, in the case where a segment with non-straight fins (1.2.1) is of a wavy type, the attachment between a straight fin section and an adjacent non-straight fin section occurs at a point corresponding to a maximum or a minimum of the wave.

14. Heat exchanger (1) according to any of the preceding claims, comprising a plurality of segments with straight fins (1.2.2) and wherein the segments with non-straight fins (1.2.1) are formed by wavy fins with a wave formed by: (a) straight segments, preferably three segments, forming a square wave, or (b) with a curved wave, preferably a sine wave, and wherein:
- at least a first segment with straight fins (1.2.2) presents an attachment with the segment with non-straight fins (1.2.1) in a maximum of the wave;
- at least a second segment with straight fins (1.2.2), different from the first segment, presents an attachment with the segment with non-straight fins (1.2.1) in a minimum of the wave;
such that the first segment with straight fins (1.2.2) is shifted with respect to the second segment with straight fins (1.2.2) in the direction transverse to the flow to restrict the passage between the turbulator (1.2) and the conduit on either side of the turbulator.

15. Heat exchanger module, comprising:
- a heat exchanger (1) according to any of the preceding claims; and
- at least one external element or component (D) placed outside the conduit of the heat exchanger (1) and said at least one external element or component (D) occupying a heat exchange region close to or in contact with the wall of the at least one conduit of the heat exchanger (1).
